(19) Europäisches Patentamt
European Patent Office
Office européen des brevets

(11) **EP 1 801 268 B1**

(12) **EUROPEAN PATENT SPECIFICATION**

(45) Date of publication and mention
of the grant of the patent:
**29.06.2011 Bulletin 2011/26**

(51) Int Cl.:
***C30B 29/06*** (2006.01)

(21) Application number: **05780922.0**

(22) Date of filing: **24.08.2005**

(86) International application number:
**PCT/JP2005/015349**

(87) International publication number:
**WO 2006/025238 (09.03.2006 Gazette 2006/10)**

(54) **MAGNETIC FIELD APPLICATION METHOD OF PULLING SILICON SINGLE CRYSTAL**

MAGNETFELDANLEGUNGSVERFAHREN ZUM ZIEHEN VON SILICIUMEINKRISTALLEN

PROCÉDÉ D"APPLICATION D"UN CHAMP MAGNÉTIQUE POUR LA CROISSANCE D"UN MONOCRISTAL DE SILICIUM

(84) Designated Contracting States:
**DE**

(30) Priority: **02.09.2004 JP 2004255104**

(43) Date of publication of application:
**27.06.2007 Bulletin 2007/26**

(73) Proprietor: **SUMCO Corporation**
**Tokyo 105-8634 (JP)**

(72) Inventors:
• **FU, Senrin**
**c/o SUMCO CORPORATION**
**Tokyo 1058634**
**(JP)**
• **ONO, Naoki**
**c/o SUMCO CORPORATION**
**Tokyo 1058634**
**(JP)**

(74) Representative: **Banzer, Hans-Jörg et al**
**Kraus & Weisert**
**Patent- und Rechtsanwälte**
**Thomas-Wimmer-Ring 15**
**80539 München (DE)**

(56) References cited:
**JP-A- 1 024 090        JP-A- 9 188 590**
**JP-A- 10 120 485       JP-A- 11 139 899**
**JP-A- 2003 055 091     JP-A- 2004 051 475**
**US-B1- 6 458 204**

**Description**

TECHNICAL FIELD

The present invention relates to a magnetic-field-applied single crystal pulling method for growing a silicon single crystal by pulling the silicon single crystal from a silicon melt while applying a magnetic field to the silicon melt.
Priority is claimed on Japanese Patent Application No. 2004-255104, filed September 2, 2004, the content of which is incorporated herein by reference.

BACKGROUND ART

The Czockralski method (hereafter referred to as CZ method), has been known as a method for growing a silicon single crystal ingot. In the CZ method, a high-purity silicon single crystal for a semiconductor is grown from a silicon melt contained in a crucible. The silicon melt is retained at a constant temperature by heating the melt by a carbon heater provided to the circumference of the quartz crucible. A mirror-etched seed crystal is made to contact the silicon melt, and a silicon single crystal ingot is grown by pulling the seed crystal while rotating the seed crystal. In this method for growing a silicon single crystal ingot, after pulling the seed crystal and forming a drawing portion from the silicon melt, the diameter of the crystal is gradually increased to the target diameter so as to form a shoulder portion, and a body portion of the silicon single crystal ingot is formed by continuous pulling.
A silicon crystal contains impurities. For example, the impurities in the silicon crystal are caused by dopants such as boron or phosphorous which are intentionally doped in the silicon melt so as to control the resistivity, or by oxygen which is eluted from the wall of the quartz crucible and is mixed in the silicon melt during the crystal pulling. Those impurities affect the quality of silicon wafers sliced from the silicon single crystal ingot, and therefore must be controlled appropriately. Especially, it is important to homogenize radial distribution of impurity concentration in order to homogenize the in-plane distribution of the impurities in the wafer.
Since the melt in the crucible is heated by the heater from the periphery of the crucible, a natural convection is generated such that the melt flows upward in the vicinity of the side wall of the crucible and flows downward in the central portion of the crucible. Therefore, the crucible is rotated so as to inhibit the natural convection caused by the heating of the silicon melt, and the silicon single crystal ingot being pulled is also rotated so as to generate a forced convection, so called Cochran flow, of the silicon melt caused by the rotation of the silicon single crystal ingot. In order to homogenize the distribution of the impurity concentration, it is necessary to control those convections effectively.
Conventionally, in order to control the silicon melt convention, a technique called MCZ (Magnetic Field Applied Czochralski) method has been applied, where a pair of exciting coils are disposed outside the chamber so as to interpose the chamber, and a static magnetic field in the transversal direction is applied to the melt in the crucible while pulling a single crystal by the Czochralski method (for example, Japanese Patent No. 3520883).
In the technique to apply the horizontal magnetic field to the silicon melt, in order to effectively control the flow rate of the melt in the vicinity of the inner surface of the crucible, an exciting coil is provided such that the vertical center of the exciting coil, where the strongest magnetic field is generated, is positioned lower than the melt surface. In that technique, by applying the strongest horizontal magnetic field, it is possible to control the melt convection, stabilize the form of solid-liquid interface constituted of the boundary between the silicon single crystal ingot and the silicon melt, and increase the pulling rate of the single crystal.
JP 01/24090 A shows the situation, where the vertical centres of the exciting coils are positioned above the surface of the silicon melt.
JP 11/139899 A shows an arrangement, where magnetic coils are aligned such that a line connecting centre of the two magnetic coils is set a level in the vicinity of the surface of the silicon melt.
JP 10/120485 discloses a HMC2 method to produce silicon single crystal with saddle-type of coils, inducing the change of strength of the magnetic field.

DISCLOSURE OF INVENTION

Problems to be solved by the invention

However, strength of the transverse magnetic field applied by the exciting coil tends to decrease at a position distant in the upward or downward direction from a horizontal section of the magnetic field showing the highest strength. Therefore, where vertical centers of exciting coils showing the highest strength of the magnetic field are positioned lower than the melt surface, accompanied with a slight vertical fluctuation of the melt surface caused by the pulling of the single crystal ingot, the strength of the magnetic field also changes in the vicinity of the solid-liquid interface that constitutes the boundary between the silicon single crystal ingot and the silicon melt. Where the strength of the magnetic field changes in the vicinity of the solid-liquid interface, it is impossible to sufficiently control the convection of the silicon melt. Therefore, the solid-liquid interface cannot have a stable form, causing difficulty in controlling the pulling rate or the diameter of the silicon single crystal ingot. In addition, because of the frequent changes of the melt convection, radial distribution of oxygen concentration is made heterogeneous. An object of the present invention is to provide a magnetic field applied pulling method for pulling a silicon single crystal, which is capable of controlling a convection of silicon melt in the vicinity of solid-liquid interface by depressing the change of the strength of the magnetic field in the vicinity of the solid-liquid interface accompanied with the pulling of the single crystal ingot.

Expedient for solving the problem

A first aspect of the present invention is an improvement of a method for pulling a silicon single crystal as claimed in claim 1. A silicon melt is stored in a quartz crucible provided in a chamber. The silicon melt is applied with a horizontal magnetic field generated by a pair of exciting coils which are provided on both sides of the chamber. A seed crystal provided to the lower end of a wire cable is immersed in the silicon melt and is pulled up while rotating the wire cable, thereby forming a silicon single crystal ingot beneath the elevating seed crystal.

In this aspect, the exciting coils are disposed outside of the chamber such that vertical centers of the exciting coils in a vertical direction are positioned upper than a surface of the silicon melt, and a distance D of the vertical center A of each exciting coil from the surface of the silicon melt satisfies the following equation (1):

$$0,1L \leq D \leq 0,8L \qquad \ldots\ldots(1),$$

where, L is the depth of the silicon melt when the pulling of the silicon single crystal ingot is started.

In the magnetic filed applied method for pulling a silicon single crystal according to the first aspect, the vertical centers A of exciting coils in the vertical direction are positioned upper than the surface of the silicon melt. Therefore, the strength of the magnetic field applied to the silicon melt has the highest strength at the surface of the silicon melt, and the strength of the magnetic field gradually decreases towards lower direction with increasing distance from the surface. Since the strength of the magnetic field is highest at the surface of the silicon melt, in spite of slight fluctuation of the strength of the magnetic field in the vicinity of the solid-liquid interface as a boundary between the silicon crystal ingot and the silicon melt, convection of the silicon melt in the vicinity of the solid-liquid interface can be controlled sufficiently compared with the conventional case where the magnetic field has the highest strength at a position lower than the surface of the silicon melt.

Where the distance D of the vertical center A of each exciting coil from the surface of the silicon melt has a negative value, that is, where the centers A of the exciting coils in the vertical direction are positioned lower than the surface of the silicon melt, it is difficult to control the convection of the silicon melt in the vicinity of the solid-liquid interface. Where the distance D exceeds 10L, it causes complication of the pulling apparatus. According to the invention, D is not less than 0.1 L and not more than 0.8L.

As a second aspect of the present invention, in the magnetic field applied pulling method for pulling a silicon single crystal according to the first aspect, the strength of the magnetic filed applied to the silicon melt in the vicinity of the solid-liquid interface between the silicon melt and the silicon single crystal ingot pulled from the melt may be 10 to 1000 milli tesla.

In this magnetic field applied pulling method for pulling a silicon single crystal, convention of the silicon melt in the vicinity of the solid-liquid interface can be sufficiently controlled. Where the strength of the magnetic field applied to the silicon melt in the vicinity of the solid-liquid interface is less than 10 millitesla, it is difficult to control the oxygen concentration. Where the strength of the magnetic field exceeds 1000 millitesla, it is difficult to control the convection of the silicon melt in the vicinity of the solid-liquid interface, and the pair of the exciting coils and a power supply for energizing the exciting coils have large dimensions.

Preferably, the strength of the magnetic field applied to the silicon melt in the vicinity of the solid-liquid interface may be 50 to 800 millitesla, more preferably, 80 to 500 millitesla.

As a third aspect of the invention, in the above-described method for pulling a silicon single crystal according to the first or second aspect, each of the exciting coils may comprise: an upper semicircular arch-shaped portion horizontally extending along the outer surface of the chamber, a lower semicircular arch-shaped portion which is positioned below the upper semicircular arch-shaped portion with a predetermined spacing in between and horizontally extending along the outer surface of the chamber; and a pair of straight portions connecting each end of the upper semicircular arch-shaped portion and lower semicircular arch-shaped portion.

In this magnetic filed applied pulling method for pulling a silicon single crystal, by the use of the above-described exciting coils, it is possible to reduce the decreasing rate of strength of the magnetic filed which is proportional to the distance in upper or lower direction from the vertical centers A of exciting coils showing highest strength of the magnetic field, and it is possible to sufficiently control the convection of silicon melt in the vicinity of the solid-liquid interface even though the vertical centers A are positioned upper than the surface of the silicon melt. As a result, the solid-liquid interface and the thermal gradient in the axial direction of the single crystal ingot being pulled do not easily suffer from influence of the position and the strength of the magnetic field. Therefore, by homogenizing the form of the solid-liquid interface and the thermal gradient in the axial direction of the single crystal ingot, it is possible to obtain a silicon single crystal ingot having a stable oxygen concentration.

[Effect of the invention]

In the magnetic field applied pulling method for pulling a silicon single crystal according to the present invention, vertical centers of the exciting coils showing highest strength of the magnetic field is positioned upper than the surface of the silicon melt. Therefore, the magnetic field applied to the silicon melt has the strongest strength at the surface of the silicon melt, and the strength of the magnetic field gradually decreases with increasing distance towards lower direction from the melt surface. Therefore, even though the surface of the silicon melt slightly fluctuates in the vertical direction in accordance with pulling of the single crystal ingot, it is possible to reduce the influence of the fluctuation on the form of the solid-liquid interface compared with the conventional case where the strongest magnetic field is positioned below the melt surface. Where the strength of the magnetic field applied to the silicon melt in the vicinity of the solid-liquid interface between the silicon melt and the silicon single crystal pulled from the melt is 10 to 1000 millitesla, it is possible to reduce the convection of the silicon melt sufficiently in the vicinity of the solid-liquid interface.

Where the exciting coil comprises: an upper semicircular arch-shaped portion horizontally extending along the outer surface of the chamber; a lower semicircular arch-shaped portion which is positioned below the upper semicircular arch-shaped portion with a predetermined spacing in between and horizontally extending along the outer surface of the chamber; and a pair of straight portions connecting each end of the upper semicircular arch-shaped portion and lower semicircular arch-shaped portion, it is possible to reduce the decreasing rate of strength of the magnetic field which is proportional to the distance in the vertical direction from a level defined by the vertical centers A of exciting coils where the magnetic field has the highest strength, and it is possible to sufficiently control the convection of the silicon melt in the vicinity of the solid-liquid interface even though the vertical centers are positioned upper than the surface of the silicon melt. Therefore, the shape of the solid-liquid interface and the thermal gradient in the axial direction of the single crystal ingot being pulled do not easily suffer from the influence of the position and the strength of the magnetic field. In the magnetic field applied pulling method for pulling a silicon single crystal using the above-described coils, it is possible to obtain a single crystal ingot having a stable property such as oxygen concentration by homogenizing the thermal gradient in the axial direction of the single crystal ingot.

BRIEF DESCRIPTION OF THE DRAWINGS

FIG. 1 is a schematic cross section showing a configuration of an apparatus for pulling a silicon single crystal according to an embodiment of the present invention.
FIG 2 is an enlarged view of the apparatus for pulling a silicon single crystal showing a relationship between exciting coils and a crucible.
FIG. 3 is a strabismic view showing a pair of exciting coils used in the apparatus for pulling a silicon single crystal.
FIG 4 is a graph showing results of the example according to the invention.

[Explanation of Symbols]

| 11 | Chamber |
|---|---|
| 12 | Silicon melt |
| 13 | Quartz crucible |
| 23 | Wire cable |
| 24 | Seed crystal |
| 25 | Silicon single crystal ingot |
| 41 | Exciting coil |
| 41a | Upper semicircular arch-shaped portion |
| 41b | Lower semicircular arch-shaped portion |
| 41c, 41d | Straight portion |
| L | Depth of silicon melt in the time of beginning of pulling of a silicon single crystal ingot. |

A          Center of exciting coil in the vertical direction

D          Distance of the vertical center of the exciting coil from the surface of the silicon melt.

## BEST MODE FOR CARRYING OUT THE INVENTION

In the following, the best mode for carrying out the invention is explained with reference to the drawings.

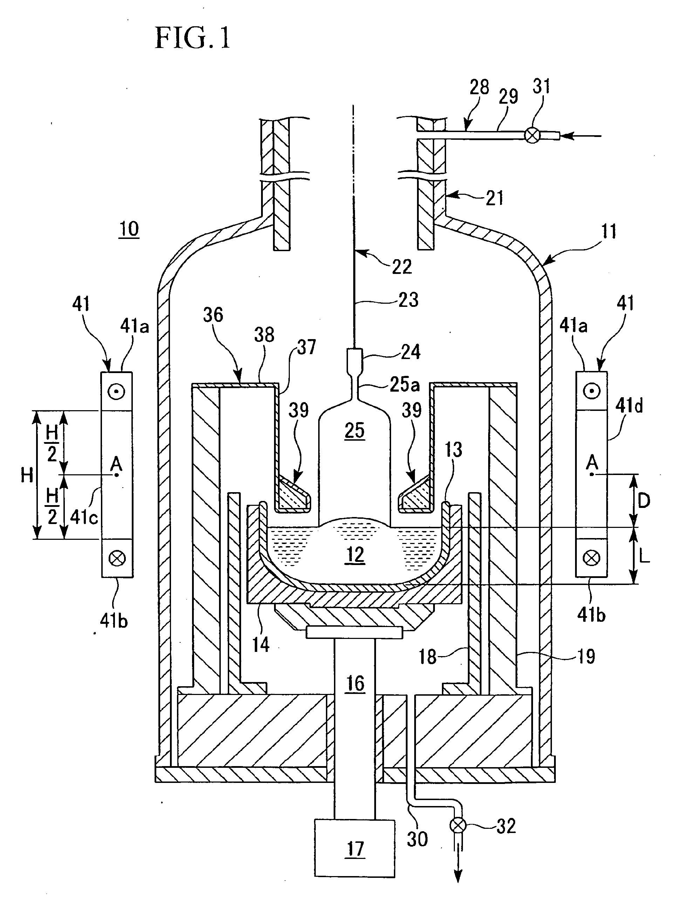

FIG. 1 illustrates an apparatus 10 for magnetic field applied pulling of a silicon single crystal according to the present invention. A quartz crucible 13 for storing a silicon melt 12 is placed in a chamber 11 of the apparatus 10. The outer surface of the apparatus is covered by a graphite susceptor 14. With the graphite susceptor 14 in between, the lower face of the quartz crucible 13 is fixed to the upper end of a support shaft 16. A lower part of the support shaft 16 is connected to a crucible driving unit 17. The crucible driving unit 17 comprises a first rotation motor (not shown) for rotating the quartz crucible 13, and vertical driving motor (not shown) for driving the quartz crucible 13 in an upward or downward direction. By these motors, the quartz crucible 13 may be rotated in a predetermined direction and may be moved in the vertical direction. The outer surface of the quartz crucible 13 is surrounded by a heater 18 with a predetermined spacing in between. The heater 18 is surrounded by a heat-insulating mould 19. Polycrystalline materials of high purity silicon are loaded in the quartz crucible 13, heated and molten by the heater, and are converted to a silicon melt 12.

A cylindrical casing 21 is connected to the upper end of the chamber. A pulling unit 22 is provided to the casing 21. The pulling unit comprises: a pulling head (not shown) which is disposed on a top end part of the casing 21 such that the head can be turned in a horizontal state; a second rotation motor (not shown); a wire cable 23 suspended from the head towards the rotation center of the quartz crucible 13; and a pulling motor (not shown) which is provided in the head for winding and unwinding of the wire cable 23. A lower end of the wire cable 23 is attached with a seed crystal 24 which is immersed in the silicon melt 12 for pulling of a silicon single crystal 25.

A gas ventilating unit 28 is connected to the chamber 11 so as to supply an inert gas to a side of the silicon single crystal in the chamber 11 and exhaust the gas from a side of the inner peripheral face of the crucible. The gas ventilating unit 28 comprises a supply pipe 29, one end of which is connected to the peripheral wall of the casing 21, and the other end of which is connected to a tank for storing the inert gas; and an exhaust pipe 30 ,one end of which is connected to the bottom wall of the chamber 11 and the other end of which is connected to a vacuum pump (not shown). First and second flow controlling pipes 31, 32 are respectively provided to the supply pipe 29 and the exhaust pipe 30 so as to control the flow rate of the inert gas flowing in the pipes 29, 30.

On the other hand, an encoder (not shown) is connected to an output axis (not shown) of the pulling motor. An encoder (not shown) is provided to the crucible-driving unit 17 for detecting a vertical position of the support shaft 16. Output of the detection of each of the two encoders is connected to a controlling input of a controller (not shown). Controlling outputs of the controller are connected to a pulling motor of the pulling unit 22 and an elevating motor of the crucible driving unit. A memory (not shown) is provided in the controller. The winding length of a wire cable 23, that is a pulling length of a silicon single crystal ingot 25, corresponding to the detection output of the encoder is recorded as a first map in the memory. The surface level of the silicon melt 12 in the quartz crucible 13 corresponding to the pulling length of the silicon single crystal ingot 25 is recorded as a second map in the memory. The controller is configured such that the surface level of the silicon melt 12 in the quartz crucible 13 is continuously maintained at a constant level by controlling of the elevating motor of the crucible driving unit 17 based on the detection output of the encoder in the pulling motor.

A heat shield member 36 is provided between the outer periphery of the silicon single crystal ingot 25 and the inner periphery of the quartz crucible 13 such that the outer periphery of the silicon single crystal ingot 25 is surrounded by the heat shield member 36. The heat shield member 36 is formed to have a cylindrical shape and comprises a cylinder portion 37 shielding radiation heat from the heater 18, and a flanged portion 38 which is joined to an upper end of the cylinder portion 37 and projecting nearly horizontally towards the outward direction. By placing the flanged portion 38 on the heat-insulating mould 19, the heat shield member 36 is fixed in the chamber 11 such that the lower edge of the cylinder portion 37 is positioned above the surface of the silicon melt 12 with a predetermined distance in between. A protruding portion 39 protruding towards the inner direction of the cylinder is provided in the lower portion of the cylinder portion 37.

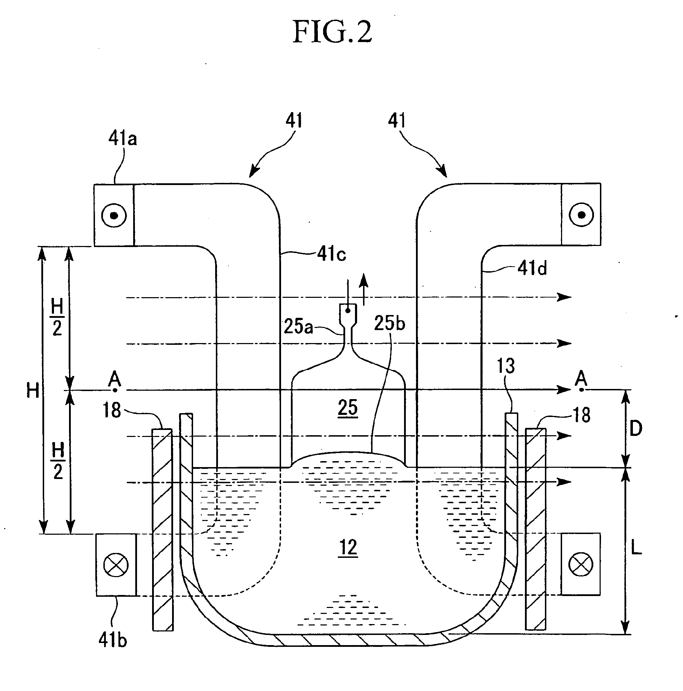

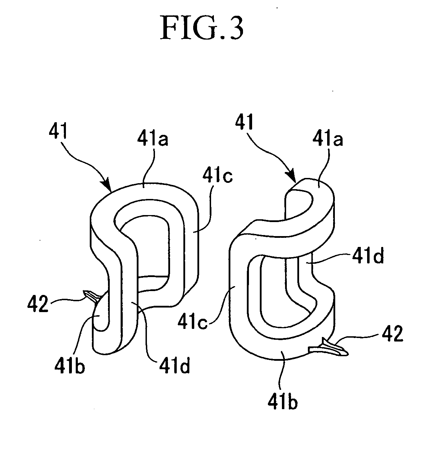

A pair of exciting coils 41, 41 are provided such that the chamber 11 is interposed between the coils. As shown in FIG. 2 and FIG. 3, the pair of exciting coils have a similar shape and dimension with each other. As an example, the shape of one of the exciting coils 41 is explained in the following. The exciting coil 41 comprises: an upper semicircular arch-shaped portion 41 a horizontally extending along the outer surface of the chamber 11; a lower semicircular arch-shaped portion 41b which is positioned below the upper semicircular arch-shaped portion with a predetermined spacing H in between and horizontally extending along the outer surface of the chamber 11; and a pair of straight portions 41c, 41d connecting each end of the upper semicircular arch-shaped portion 41 a and lower semicircular arch-shaped portion 41 b. In the present embodiment, the spacing H is 5 to 500 cm. The pair of exciting coils 41, 41 are connected serially by the power lead wire 42. As shown in FIG. 2, where the exciting coils 41, 41 are energized by the power source (not shown), magnetic field is generated in the horizontal direction connecting the centers A of the pair of the coils 41, 41.

In FIG. 1, the pair of magnetic coils 41, 41 are placed outside the chamber 11 such that the center of each of the magnetic coils 41, 41 in a vertical direction is positioned upper than the surface of the silicon melt 12 and is removable in the vertical direction.

Next, the pulling method in accordance with the present invention utilizing this apparatus for pulling a silicon single crystal is explained.

As shown in FIG. 1, polycrystalline materials of high purity silicon and impurities constituting dopant are loaded in the quartz crucible 13. The polycrystalline materials of high purity silicon are heated and molten by a carbon heater 18 and are converted to the silicon melt 12. Where L denotes the depth of the silicon melt 12 when the pulling of the silicon single crystal ingot 25 is started, and D denotes the distance of the vertical center A of each of the exciting coils 41, 41 from the surface of the silicon melt 12, the vertical position of the pair of exciting coils 41, 41 is determined such that the distance D is not less than 0 and not more than 10L. That is, the distance D is expressed by the following equation (1);

$$0 \leq D \leq 10L \qquad\qquad ........(1)$$

After melting the polycrystalline silicon, storing the silicon melt 12 in the quartz crucible 13, and determining the vertical position of the pair of the exciting coils 41, 41, each of the exciting coils is energized by the power supply such that a magnetic flux is generated in the horizontal direction connecting the two exciting coils 41, 41. On the other hand, the magnetic field generated by the exciting coils 41, 41 has the highest strength in the horizontal magnetic field, shown by the solid line, generated in the level of the vertical centers of the exciting coils. In the horizontal magnetic field, shown by the chain lines, generated in the position vertically distant from the horizontal magnetic field shown by the solid line, the strength of the magnetic field is decreased in proportional to the distance from the magnetic field shown by the solid line. Therefore, the strength of the magnetic field applied to the silicon melt 12 is strongest at the surface of the silicon melt 12, and the strength of the magnetic field gradually decreases in the lower direction in accordance with a distance from the melt surface. In the present embodiment, the strength of the magnetic field applied to the vicinity of the solid-liquid interface between the silicon melt 12 and the silicon single crystal 25 pulled up from the melt is 10 to 1000 millitesla.

Subsequently, the quartz crucible 13 is rotated at a predetermined speed, through the support shaft, by the crucible-driving unit 17. Then, the seed crystal 24 is lowered by unwinding the wire cable 23 by the pulling motor (not shown) of the rotation pulling unit, and the end portion of the seed crystal 24 is made to contact the silicon melt 12. After that, by gradually pulling the seed crystal 24, a seed drawing portion 25a is formed. A silicon single crystal ingot 25 is grown beneath the seed crystal 24. When the silicon single crystal ingot 25 is pulled, the wire cable is rotated such that the seed crystal 24 is rotated in a clockwise direction with a predetermined speed.

In the silicon melt 12 applied with the horizontal magnetic field 12, since the centers of the exciting coils 41, 41 showing a strongest magnetic field are positioned upper than the surface of the silicon melt, the magnetic field applied to the silicon melt 12 has a highest strength at the surface of the silicon melt, and the strength of the magnetic field gradually decreases with increasing distance towards lower direction from the melt surface. The strength of the magnetic field in the vicinity of the solid-liquid interface as a boundary between the silicon single crystal ingot and the silicon melt slightly changes in accordance with the slight vertical fluctuation of the surface of the silicon melt 12 in accordance with the pulling of the single crystal ingot 25. However, since the magnetic field has the largest strength at the surface of the silicon melt 12, convection of the silicon melt 12 in the vicinity of the solid-liquid interface is sufficiently controlled compared with the case where the strongest magnetic field is positioned below the melt surface.

As a result, a stable control of the shape of the solid-liquid interface is enabled. By pulling the silicon single crystal ingot 25 from the silicon melt 12 in accordance with a pulling rate profile predetermined based on Voronkov's theory, it is possible to produce a silicon single crystal ingot 25 which does not include aggregates of interstitial silicon type point defects.

In Voronkov's theory, in order to grow a high purity silicon single crystal ingot 25 containing only a small number of defects, where V (mm/minute) denotes the pulling rate of the silicon single crystal, and G (°C/mm) denotes a thermal gradient in the silicon single crystal ingot in the vicinity of the interface between the silicon single crystal ingot and the silicon melt 12, the ratio V/G ($mm^2$/minute°C) is controlled.

Example 1

Where L denotes the depth of the silicon melt 12 when the pulling of the silicon single crystal ingot 25 is started, and D denotes the distance of the vertical center A in of each of the exciting coils 41, 41 from the surface of the silicon melt 12, D was shifted from -2.1L to +3.2L. In that time, a variation of vertical dimension of the solid-liquid interface in a vertical direction, and a variation of thermal gradient in the center axis of a thus pulled silicon single crystal ingot 25 were determined by a least-square method.

In the expression of D, a minus symbol denotes the case where the vertical centers A of the exciting coils 41, 41 are positioned lower than the surface of the silicon melt 12, and the plus symbol denotes a case where the vertical centers A of the exciting coils 41, 41 are positioned upper than the surface of the silicon melt 12. The vertical dimension of the solid-liquid interface is expressed by a ratio between the maximum height and the mean height of the solid-liquid interface formed in the time of pulling a silicon single crystal ingot.

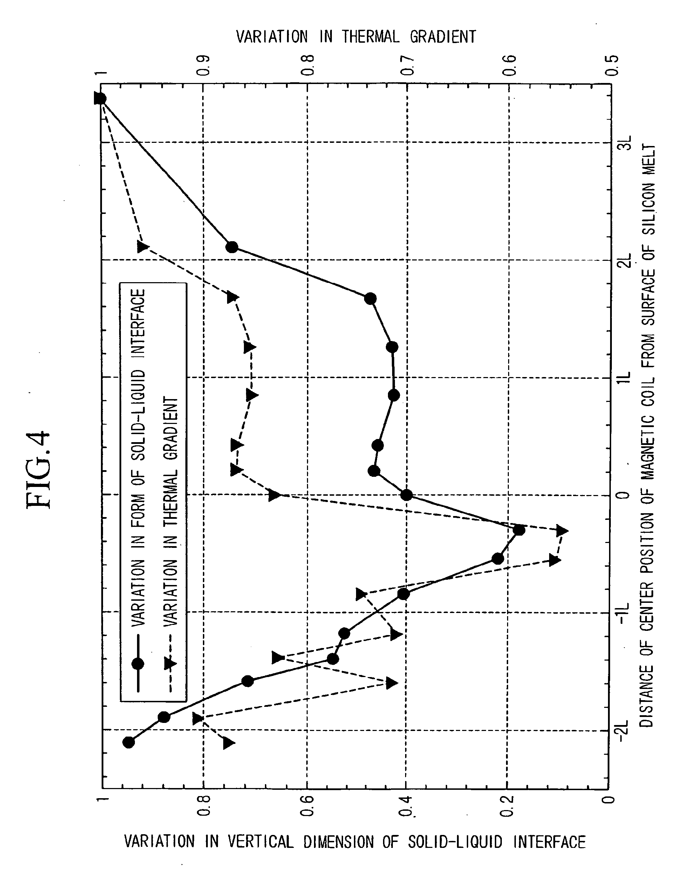

The variation in the thermal gradient in the center axis of the silicon single crystal ingot 25 was expressed by a ratio between the maximum value and mean value in the vicinity of the solid-liquid interface formed in the time of pulling a silicon single crystal ingot. The results are shown in FIG. 4.

As shown by the results of FIG. 4, where the center A of each of the exciting coils 41, 41 is positioned lower than the surface of the silicon melt 12, the variation in the vertical dimension of solid-liquid interface and variation in the thermal gradient corresponding to the distance D of the vertical center A of each of the exciting coils 41, 41 from the surface of the silicon melt 12 are relatively remarkable.

On the other hand, where the vertical center A of each of the exciting coils 41, 41 is positioned upper than the surface of the silicon melt 12, the variation in the vertical dimension of solid-liquid interface and the variation in the thermal gradient corresponding to the distance D of the vertical center A of each of the exciting coils 41, 41 from the surface of the silicon melt 12 do not show a large change.

Therefore, it can be understood that, in the present invention where the vertical center A of each of the exciting coils 41, 41 is positioned upper than the surface of the silicon melt 12, by controlling the change of the magnetic field in the vicinity of the solid-liquid interface in accordance with the pulling of a single crystal ingot, convection of the silicon melt in the vicinity of the solid-liquid interface is sufficiently controlled.

INDUSTRIAL APPLICABILITY

In the magnetic field applied pulling method for pulling a silicon single crystal according to the present invention, it is possible to homogenize the form of solid-liquid interface between the single crystal and the silicon melt and the thermal gradient in the axial direction, it is possible to obtain a high-quality silicon single crystal ingot having a stable property such as stable oxygen concentration.

**Claims**

1. A magnetic field applied pulling method for pulling a silicon single crystal, comprising:

   storing a silicon melt in a quartz crucible disposed in a chamber;
   providing a pair of exciting coils on both sides of the chamber;
   applying a horizontal magnetic field formed by the exciting coils to the silicon melt;
   immersing a seed crystal provided to a lower end of a wire cable in the silicon melt; and
   growing a silicon single crystal ingot beneath the seed crystal elevated by pulling the wire cable while rotating the wire cable,
   **characterized in that**
   the exciting coils are placed outside the chamber such that vertical centers of the exciting coils in a vertical direction are positioned upper than the surface of the silicon melt, and
   a distance D of the vertical center of each exciting coil from the surface of the silicon melt is not less than 0.1 L and not more than 0.8L, where L denotes a depth of the silicon melt in the beginning of pulling of the silicon single crystal ingot.

2. A magnetic field applied pulling method for pulling a silicon single crystal according to claim 1, wherein a strength of the magnetic field applied to the vicinity of the solid-liquid interface between the silicon melt and the silicon single crystal pulled from the melt is 10 to 1000 millitesla.

3. A magnetic field applied pulling method for pulling a silicon single crystal according to claim 1, wherein each of the pair of exciting coils comprises:

an upper semicircular arch-shaped portion horizontally extending along the outer surface of the chamber;
a lower semicircular arch-shaped portion which is positioned below the upper semicircular arch-shaped portion with a predetermined spacing in between and horizontally extending along the outer surface of the chamber; and
a pair of straight portions connecting each end of the upper semicircular arch-shaped portion and lower semicircular arch-shaped portion.

**Patentansprüche**

1. Ziehverfahren zum Ziehen eines Siliziumeinkristalls unter Magnetfeldanwendung, umfassend:

Speichern einer Siliziumschmelze in einem Quarztiegel, welcher in einer Kammer angeordnet ist,
Bereitstellen eines Paares von Anregungsspulen auf beiden Seiten der Kammer;
Anwenden eines durch die Anregungsspulen ausgebildeten horizontalen Magnetfelds auf die Siliziumschmelze;
Eintauchen eines Keimkristalls, welcher an einem unteren Ende eines Drahtkabels bereitgestellt ist, in die Siliziumschmelze; und
Wachsen eines Siliziumeinkristallingots unterhalb des Keimkristalls, welcher durch Ziehen des Drahtkabels angehoben wird, während das Drahtkabel rotiert wird,
**dadurch gekennzeichnet, dass**
die Anregungsspulen außerhalb der Kammer derart angeordnet sind, dass die vertikalen Mittelpunkte der Anregungsspulen in einer vertikalen Richtung weiter oben als die Oberfläche der Siliziumschmelze positioniert sind, und
ein Abstand D des vertikalen Mittelpunkts jeder Anregungsspule von der Oberfläche der Siliziumsschmelze nicht kleiner als 0,1L und nicht größer als 0,8L ist, wobei L eine Tiefe der Siliziumschmelze zu Beginn des Ziehens des Siliziumeinkristallingots bezeichnet.

2. Ziehverfahren zum Ziehen eines Siliziumeinkristalls unter Magnetfeldanwendung gemäß Anspruch 1, wobei eine Stärke des Magnetfelds, welches auf die Umgebung der Fest-Flüssig-Grenzfläche zwischen der Siliziumschmelze und dem aus der Schmelze gezogenen Siliziumeinkristall angewendet wird, 10 bis 1000 Millitesla ist.

3. Ziehverfahren zum Ziehen eines Siliziumeinkristalls unter Magnetfeldanwendung gemäß Anspruch 1, wobei jede von dem Paar von Anregungspulen umfasst:

einen oberen halbkreisförmigen bogenförmigen Abschnitt, welcher sich horizontal entlang der äußeren Oberfläche der Kammer erstreckt;
einen unteren halbkreisförmigen bogenförmigen Abschnitt, welcher unterhalb des oberen halbkreisförmigen bogenförmigen Abschnitts mit einem vorbestimmten Abstand dazwischen positioniert ist und sich horizontal entlang der äußeren Oberfläche der Kammer erstreckt; und
ein Paar von geraden Abschnitten, welche die jeweiligen Enden des oberen halbkreisförmigen Abschnitts und unteren halbkreisförmigen Abschnitts verbinden.

**Revendications**

1. Procédé d'extraction avec application de champ magnétique visant à extraire un monocristal de silicium, comprenant les étapes consistant à :

stocker une matière fondue de silicium dans un creuset en quartz disposé dans une chambre ;
fournir une paire de bobines d'excitation sur les deux côtés de la chambre ;
appliquer un champ magnétique horizontal formé par les bobines d'excitation à la matière fondue de silicium ;
immerger un germe cristallin fourni à une extrémité inférieure d'un câble métallique dans la matière fondue de silicium ; et
faire croître un lingot monocristallin de silicium en dessous du germe cristallin élevé en tirant le câble métallique tout en faisant tourner le câble métallique,
**caractérisé en ce que**
les bobines d'excitations sont placées à l'extérieur de la chambre de telle sorte que des centres verticaux des bobines d'excitation dans une direction verticale soient positionnés plus haut que la surface de la matière fondue de silicium, et

une distance D du centre vertical de chaque bobine d'excitation par rapport à la surface de la matière fondue de silicium est non inférieure à 0,1 L et non supérieure à 0,8 L, où L désigne une profondeur de la matière fondue de silicium au début de l'extraction du lingot monocristallin de silicium.

2. Procédé d'extraction avec application de champ magnétique visant à extraire un monocristal de silicium selon la revendication 1, dans lequel une intensité du champ magnétique appliqué au voisinage de l'interface solide-liquide entre la matière fondue de silicium et le monocristal de silicium extrait de la matière fondue est de 10 à 1 000 milliTesla.

3. Procédé d'extraction avec application de champ magnétique visant à extraire un monocristal de silicium selon la revendication 1, dans lequel chacune de la paire de bobines d'excitation comprend :

une portion supérieure en forme d'arc semi-circulaire s'étendant horizontalement le long de la surface externe de la chambre ;
une portion inférieure en forme d'arc semi-circulaire qui est positionnée sous la portion supérieure en forme d'arc semi-circulaire avec un espacement prédéterminé entre elles et s'étendant horizontalement le long de la surface externe de la chambre ; et
une paire de portions droites raccordant chaque extrémité de la portion supérieure en forme d'arc semi-circulaire et de la portion inférieure en forme d'arc semi-circulaire.

# FIG.1

EP 1 801 268 B1

# FIG.2

FIG.3

# FIG.4

VARIATION IN VERTICAL DIMENSION OF SOLID-LIQUID INTERFACE

VARIATION IN THERMAL GRADIENT

- ●— VARIATION IN FORM OF SOLID-LIQUID INTERFACE
- ▼-- VARIATION IN THERMAL GRADIENT

DISTANCE OF CENTER POSITION OF MAGNETIC COIL FROM SURFACE OF SILICON MELT

EP 1 801 268 B1

13

**REFERENCES CITED IN THE DESCRIPTION**

**Patent documents cited in the description**

- JP 2004255104 A
- JP 3520883 B
- JP 1024090 A
- JP 11139899 A
- JP 10120485 A